## Europäisches Patentamt

## European Patent Office

## Office européen des brevets

(19)

(11) Publication number: **0 041 857**
**B1**

(12) **EUROPEAN PATENT SPECIFICATION**

(45) Date of publication of patent specification: **12.09.84**

(51) Int. Cl.³: **B 23 K 3/06, H 01 R 43/02**

(21) Application number: **81302530.1**

(22) Date of filing: **08.06.81**

(54) **Solder delivery device.**

(30) Priority: **09.06.80 US 158034**

(43) Date of publication of application:
**16.12.81 Bulletin 81/50**

(45) Publication of the grant of the patent:
**12.09.84 Bulletin 84/37**

(84) Designated Contracting States:
**AT BE CH DE FR IT LI NL SE**

(56) References cited:
**DE-B-1 552 962**
**US-A-4 183 611**

(73) Proprietor: **RAYCHEM CORPORATION**
**300 Constitution Drive**
**Menlo Park California 94025 (US)**

(72) Inventor: **Grassauer, Wille K.**
**723 Marsh Road, No. 10**
**Menlo Park California 94025 (US)**
Inventor: **Robinson, William M.**
**4164 Wilkie Way**
**Palo Alto California 94306 (US)**

(74) Representative: **Jones, David Colin et al**
**RAYCHEM Intellectual Property Law**
**Department Swan House 37-39 High Holborn**
**London WC1 (GB)**

## Description

This invention relates to a solder delivery device, and particularly to a solder delivery device for use in terminating a plurality of closely-spaced conductors to a connector.

Joining flat cable or ribbon cable to connectors can be accomplished by a number of different methods, with soldering being probably the most reliable. However, if all the solder terminations must be done by hand, the costs involved and the time required to perform a multiplicity of repetitive soldering operations far outweigh any gains in reliability. In addition, as connector pin spacing decreases, due to high interconnection densities, the reliability of hand soldering decreases because of the possibility of solder bridging the terminations and shorting out adjacent connectors. It would therefore be desirable to have a soldering device by which all the leads can be soldered to the connector simultaneously, rapidly and reliably for a wide range of numbers of terminations and spacings.

In the past, various devices have been developed for simultaneously applying a plurality of bodies of solder to a number of closely spaced electrical terminals. According to one such system, for example, a small discrete portion of solder is positioned adjacent each terminal to be soldered, and the entire system then heated to fuse each solder portion simultaneously. Such a solder delivery device, however, requires small portions of solder to be extremely precisely positioned, and is accordingly very difficult to manufacture, GB—A—1099650, for example, describes an applicator that may be used for solder. The applicator comprises a sheet provided with a plurality of heat-recoverable cups each capable of holding a body of solder and on recovery, of ejecting the body of solder.

It is also known to use a single continuous piece of solder to solder a large number of terminals simultaneously. In one such arrangement a bare solder wire extends along a terminal strip and, on heating, the solder melts and coalesces on the individual contacts to form independent connections.

It is an object of the present invention to provide a solder delivery device that is easy to manufacture and which minimises, or at least substantially alleviates, the problems encountered with known delivery devices, such as, for example, the formation of solder bridges between adjacent terminals.

The present invention provides a solder delivery device comprising two layers of material and a strip of solder disposed therebetween, at least one of the layers having a plurality of windows therein, the windows being arranged to direct the solder from the strip to form a plurality of separate solder connections on heating the delivery device to a temperature sufficiently high to melt the solder, the material of the layers being such as to withstand said temperature.

It will be understood that it is necessary for the layers to withstand said temperature to the extent that they are able to direct the flow of solder from the solder strip on said heating of the solder delivery device. The material of the layers may be, for example, a suitable polymeric material, which may be cross linked to render it recoverable.

Several embodiments of solder delivery device each in accordance with the present invention will now be described by way of example, with reference to the accompanying drawings, wherein:

Figure 1 is an exploded view of a first embodiment of solder delivery device;

Figure 2 depicts the embodiment of Figure 1 in cross-section.

Figures 3 to 5 are sectional views depicting the use of the embodiment of Figure 1 for terminating a plurality of conductors;

Figure 6 is a sectional view depicting the use of a second embodiment of solder delivery device for terminating a plurality of conductors;

Figure 7 is a plan view showing three alternate shapes for the windows in the layer of material bordering the solder strip, for use in any of the embodiments of delivery device;

Figure 8 is a sectional view showing a third embodiment of solder delivery device employing an adhesive;

Figure 9 is a plan view showing the window-containing layer of a fourth embodiment of solder delivery device;

Figures 10 to 12 are sectional views showing the use of the embodiment of Figure 9 for terminating a plurality of conductors;

Figure 13 is a sectional view showing a fifth embodiment of solder delivery device containing a sealant;

Figures 14 and 15 are sectional views showing the use of the embodiment of Figure 13 for terminating a plurality of conductors;

Figure 16 is a perspective view of a sixth embodiment of solder delivery device where one of the layers of material bordering the solder strip has been extended and heat-recoverable features formed therein;

Figure 17 is a side elevation of the system of Figure 16 showing a use of the heat-recoverable features;

Figure 18 is a sectional view of a seventh embodiment of solder delivery device where one of the layers of material has been extended and secured to a substrate;

Figure 19 is a sectional view of an eighth embodiment employing heat-recoverable tubings;

Figure 20 is a sectional view showing the use of the embodiment of Figure 19 in terminating a plurality of conductors;

Figure 21 is a sectional view showing a folded polymeric sheet forming the layers of material of the solder delivery device;

Figure 22 is a sectional view showing a polymeric tube forming the layers of material of the solder delivery device; and

Figure 23 is a schematic view showing a method of manufacture of the windows in the solder delivery device.

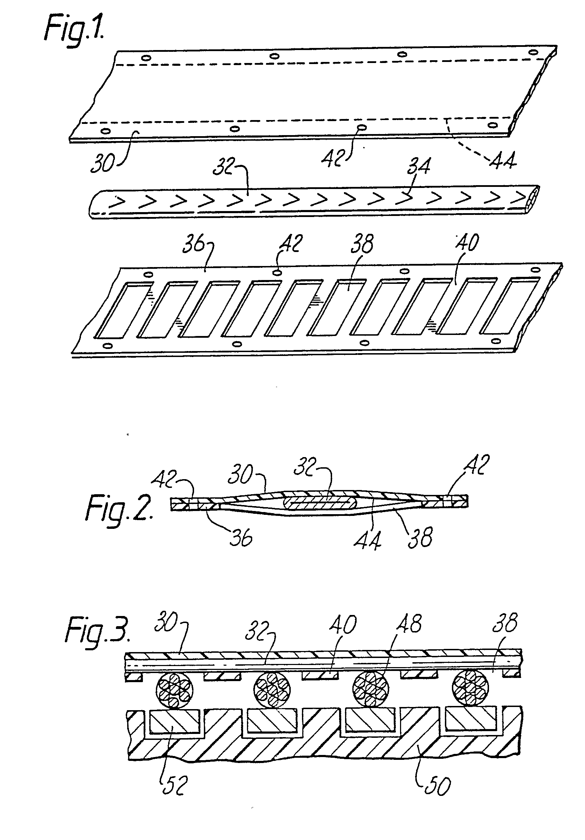

Referring to the drawings Figure 1 shows a first embodiment of solder delivery device comprising an upper polymeric layer 30, a solder strip 32, which may have perforations 34 to enable better flux flow, and a lower polymeric layer 36, having windows 38 therein. The solder strip 32 is positioned over said windows 38, the solder thereby being arranged to flow through windows 38 on melting. The windows 38 are bordered by a plurality of window frames 40.

As used herein, solder includes any metal or metallic alloy used to join metallic surfaces by melting that metal or metallic alloy and then allowing it to cool, and a solder strip includes an elongated, continuous element of solder of any cross-section, for example a round, square or flat cross-section. Such a solder strip may contain a flux core and/or may be coated on all or a part of its outer surface with a flux coating. The strip may be perforated to enable better flow of a flux core. Also, as used herein, a window includes any opening that permits solder to pass through it, the windows and bordering frames therefore acting to direct the flow of solder. Accordingly the term windows includes rectangular apertures, which may be, for example, bordered on all four sides by frames, or only on three sides the fourth side remaining open. A row of such three sided framed windows being in the form, therefore, of a generally comb shaped structure.

In the embodiment shown in Figure 1, the upper and lower polymeric layers 30 and 36 are attached together in laminate form by heat-welding at a plurality of points 42. Of course, this heat-welding may be performed along the entire edges of the polymeric layers, and not just at a series of points, if so desired. A fluxing agent 44 may be coated onto the underside of the upper polymeric layer 30 by any suitable means, either before assembly of the solder delivery device or after it has been assembled.

Figure 2 is a cross-sectional view of the first embodiment of the solder delivery device, in its assembled form. The solder strip 32 is seen to be sandwiched between the upper and lower polymeric layers 30 and 36.

Figures 3 to 5 depict the use of the solder delivery device to terminate a plurality of conductors to, for example, a connector body. In Figure 3, the device is seen in cross-section positioned above a plurality of conductors 48, each of which lies over a connector tab 52 emerging from a connector body 50. In the drawings the conductors 48 are shown aligned with the centre of the tabs 52, but is an advantage of the device of the present invention that considerable misalignment of the conductors with their corresponding tabs will not adversely affect the quality of the soldered joints produced.

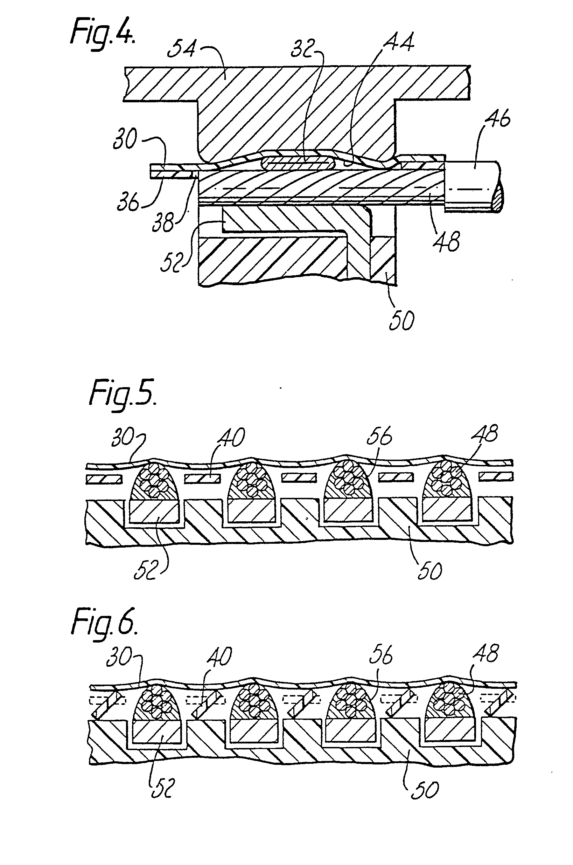

Figure 4 depicts the assembly of Figure 3 in cross-section parallel to the conductors. A wire 46 has a conductor 48 which lies above the connector tab 52. A heating tool platen 54 is shown positioned above the assembly. This platen may be heated, for example, electrically or by focused, high-intensity infrared radiation applied to its upper surface. On the application of heat and pressure the upper polymeric layer 30 rapidly softens to allow close contact between the platen 54 and the solder 32 and conductor 48. Heat rapidly transfers to the connector tab 52, as all the items have low thermal mass. The flux present, either in the flux coating 44 or associated with the solder strip 32, is directed onto the conductor and connector tab and cleans them so that the solder will form a sound joint. During the time the solder is molten, the polymeric window frames 40 will resist wetting by the molten solder and may swell due to the heating, thus effectively preventing the formation of solder bridges. The heating tool platen 54 remains in contact with the assembly throughout the heating-cooling cycle. This maintains conductor-tab contact until the solder joints are formed. The precise shape of the platen 54 may be chosen to optimize heat flow to the metal parts, while minimizing heat damage to the plastic connector body or cable insulation. While the platen 54 will generally be of unitary construction and rigid, it is also envisaged that the platen may comprise an elastomeric portion or may be of spring-loaded "piano-key" construction (with the "keys" being made, for example, from 0.64 or 1.28 mm wide leaf springs (reeds). Such a platen would accommodate connector tabs and/or conductors of different heights and thicknesses and ensure the application of adequate pressure and heat to the joints.

Figure 5 shows the completed termination, where flowed solder 56 joins the conductors 48 to the connector tabs 52. The window frames 40 help to prevent the formation of solder bridges between adjacent conductors or tabs.

Figure 6 depicts a completed termination when a second embodiment of the device has been used. In this second embodiment, the lower polymeric layer has been rendered recoverable, and in this case heat-recoverable, in such a way that, on heating, the window frames 40 rotate, as shown by the arrows, from their original positions (shown in phantom) so as to block the flow of solder between adjacent conductors more effectively.

A heat-recoverable article such as the lower, heat-recoverable, polymeric, layer of Figure 6, is an article the dimensional configuration of which may be made substantially to change when subjected to heat treatment.

Usually these articles recover, on heating, towards an original shape from which they have previously been deformed but but the term "heat-recoverable", as used herein, also includes an article which, on heating, adopts a new configuration, even if it has not been previously deformed.

In the production of heat-recoverable articles, the polymeric material may be cross-linked at any stage in the production of the article that will enhance the desired dimensionally recoverability. One manner of producing a heat-recoverable article comprises shaping the polymeric material into the desired heat-stable form, subsequently cross-linking the polymeric material, heating the article to a temperature above the crystalline melting point or, for amorphous materials the softening point, as the case may be, of the polymer, deforming the article and cooling the article whilst in the deformed state so that the deformed state of the article is retained. In use, since the deformed state of the article is heat-unstable, application of heat will cause the article to assume its original heat-stable shape.

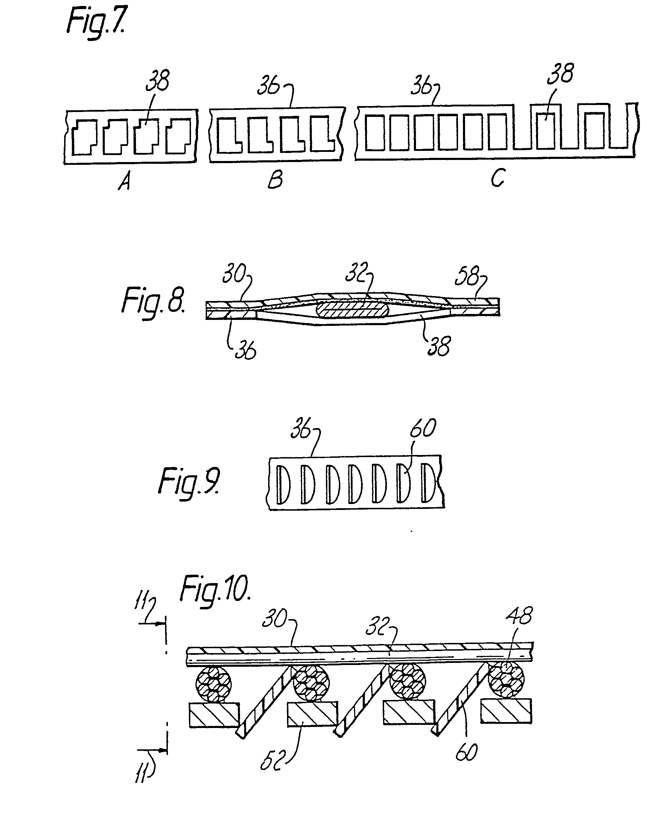

Figure 7 shows some possible alternative shapes of the window means for different connector designs. In Figure 7A, inset corners are used to align the solder strip in the centre of the windows; in Figure 7B, at the bottom edge. The windows may also be shaped to aid in directing the solder flow. In Figure 7C, portions of the lower polymeric layers have been cut away to accommodate connector features, and to direct the flow of solder transversely of the row of windows.

Figure 8 depicts a third embodiment of the solder delivery device. In this embodiment, the upper and lower polymer layers 30 and 36 are not heat-welded together, but rather are joined by an adhesive 58. This adhesive also serves to locate the solder strip 32. The adhesive may be a pressure-sensitive adhesive, for example, one coated on the upper polymeric layer 30 before assembly, or may be a curable adhesive such as one cured by ultraviolet light or radiation. An advantage of curable adhesive is that it may be rendered non-flowing at soldering temperatures. If a radiation-curable adhesive is employed, cross-linking of the polymeric layers (if desired) and curing of the adhesive may be performed simultaneously.

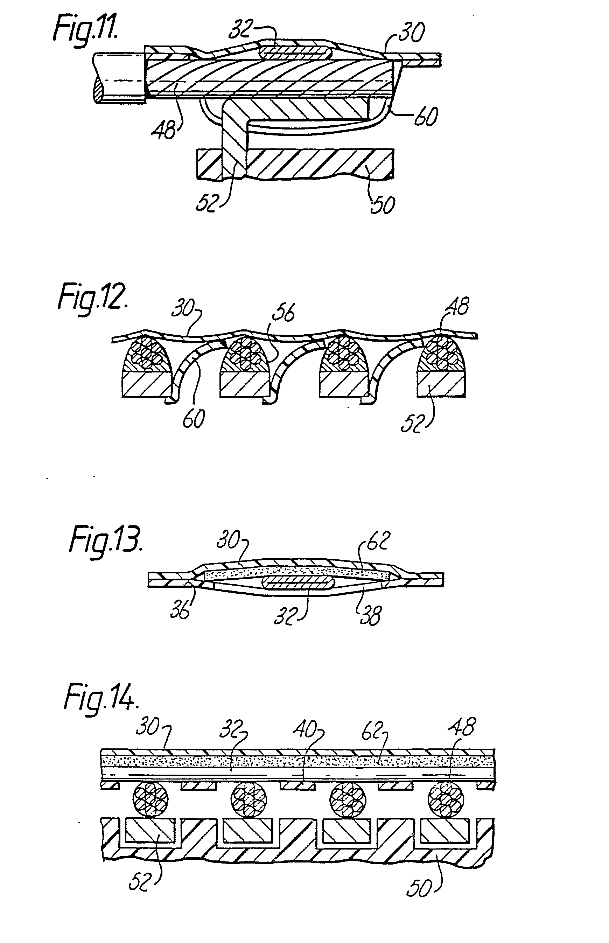

In Figure 9, the lower polymeric layer 36 of a fourth embodiment is shown. In this embodiment, windows have not been cut out from the layer but louvered windows 60 have been formed in it. As with the layer of the second embodiment, this layer 36 has been rendered heat-recoverable.

Figure 10 depicts the embodiment of Figure 9 in use, the louvers 60 completely separating the conductor-tab pairs from each other.

A cross-sectional view in the direction indicated by the arrows in Figure 10 is shown in Figure 11, illustrating the manner in which the louvers 60 act.

Figure 12 depicts the assembly of Figure 10 after heating. The flowed solder 56 has joined the conductors 48 to tabs 52, while the louvers 60 have recovered to pull the upper layer 30 towards the joint. Such an arrangement is especially suitable when it is intended that the polymeric layers remain in place on the joints instead of being removed.

Figure 13 shows in cross-section a fifth embodiment of the solder delivery device which additionally comprises a sealant 62. Such a sealant may be, for example, a thermo-plastic, hot-melt, mastic.

In Figure 14, the device of Figure 13 is shown positioned above a set of conductors 48 and a connector having tabs 52.

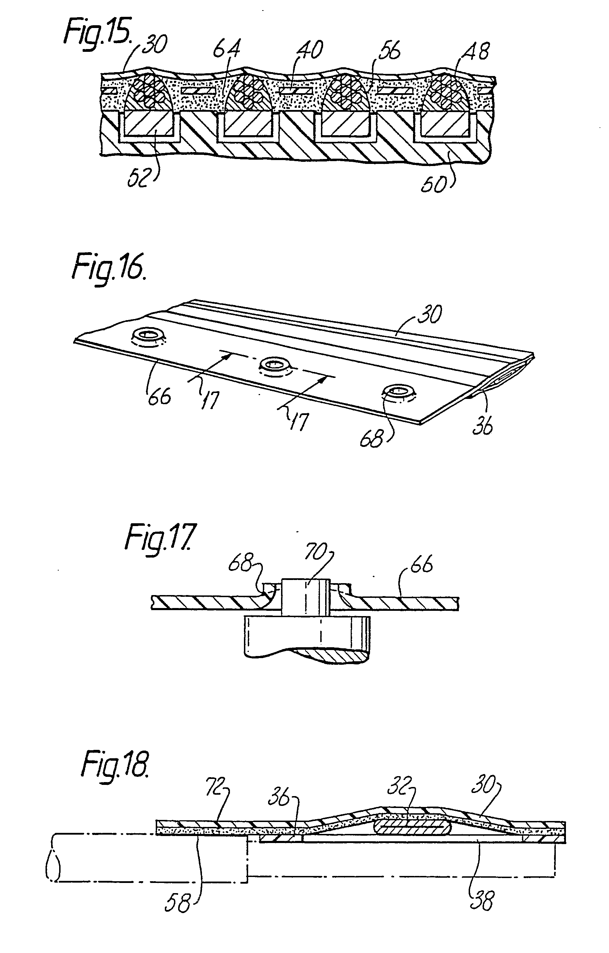

In Figure 15, the assembly of Figure 14 is shown after heating. The flowed solder 56 forms joints between the conductors 48 and tabs 52 while the flowed sealant 64 encapsulates these joints. The use of a sealant stabilizes the joints, lengthens the electrical leakage paths, and helps to immobilize conductive or ionic materials. This use is particularly appropriate when it is intended that the upper polymeric layer 30 should remain in place above the conductors 48.

In Figure 16, a sixth embodiment of solder delivery device is shown. One or both of the polymeric layers have been extended to form an extension 66, into which have been introduced additional heat-recoverable features, in this case, alignment holes 68. The alignment holes 68 may be used for example, as a fastening socket in this extension 66.

Figure 17 shows a mode of use of the heat-recoverable features 68 shown in Figure 16. When the features 68 are placed over a boss 70, for example, a locating boss on the body of the connector on which the device is to be employed, and heated, such as when the solder joints are made, the features recover to the position shown in phantom to lock the polymeric layers onto the boss. Especially if the boss is mushroom-shaped, the device will be fastened to the boss in such a way that removal will require substantial force.

In Figure 18, a seventh embodiment is shown, wherein the upper polymeric layer 30 has been extended to form an extension 72 which is coated with an adhesive 58. Use of this embodiment enables the strip to be fastened to, for example, the cable as shown in phantom, which is to be terminated to a connector. Although only one side of the layer 30 has been shown extended, it is of course possible for both sides to be extended to adhere to both the cable and a connector. In this way, the soldered joints may be completely encapsulated.

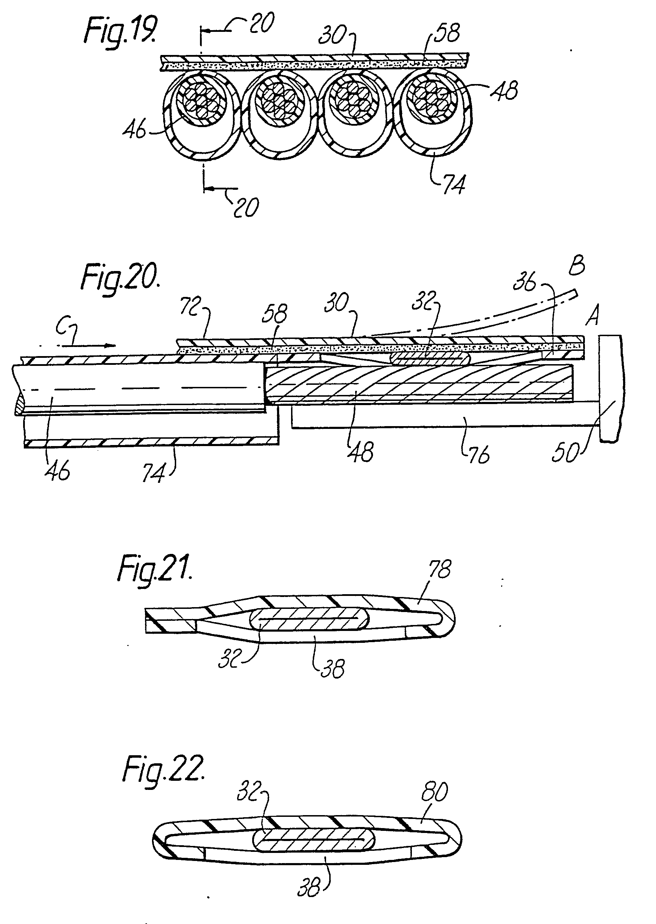

Figure 19 depicts an eighth embodiment of the solder delivery device in which a plurality of heat-shrinkable tubes 74 have been attached by adhesive to the extension 72 of the upper polymeric layer 30. This embodiment is particularly suitable for termination of individual conductors and/or terminations to protruding tabs.

Figure 20 shows the mode of use of this embodiment. Tabs 76 protrude from connector body 50. Each of a plurality of wires 46 is placed through a heat-shrinkable tube 74 so that the conductor 48 lies over a tab 76. Then, with the body of the solder delivery device in position A, the assembly is heated in only the region of the tabs so as to solder the conductors to the tabs. When the soldering operation is complete, the upper polymeric layer is pulled up to position B (shown in phantom) and the tubes 74 slid forward in the direction of arrow C by pulling on the layer 30. When the tubes 74 each completely cover the soldered tab-conductor pairs, the polymeric layer 30 may be peeled completely free and the tubes 74 shrunk, by e.g., a hot-air gun or infrared lamp, to completely insulate the joints.

In Figure 21, a ninth embodiment is shown, in which the upper and lower polymeric layers 30 and 36 are part of a single polymeric sheet 78 which is folded about the solder strip 32 after the windows 38 have been formed in the sheet 78. The upper and lower layers 30 and 36 may be joined on the side opposite the fold by any suitable method, such as heat-welding or the use of an adhesive. While Figure 21 depicts only the simplest form of this embodiment and corresponds generally to Figures 2 and 8 in that regard, it is of course possible for other features such as, for example, the heat-recoverable window frames of Figures 6 or 9, the sealant of Figure 13, or the extensions of Figures 16—20 to be incorporated together with the folded sheet feature of this embodiment.

Figure 22 illustrates a tenth embodiment in which the upper and lower polymeric layers are part of a polymeric tube 80. Windows 38 have been formed in this tube 80 and the tube flattened in such a way that the solder strip 32, which has been inserted in the tube, lies above the window means 38. A sealant or adhesive may also be placed within the tube, though this is not depicted in the Figure.

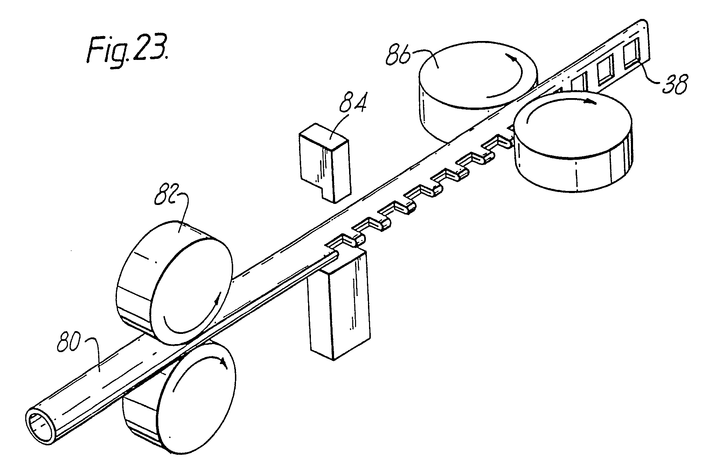

Figure 23 illustrates a method of forming the windows 38 in the tube 80 of Figure 22. The tube is flattened by a set of rollers 82 and a punch or cutter 84 used to cut one edge of the flattened tube. The tube may then be re-flattened by a set of rollers 86 at 90° to the first set of rollers 82, to provide windows 38. The tube may be used without reflattening when windows through more than one layer and openings to the side are desired. Depending on the polymer properties, a simple re-flattening of the tube may be sufficient to form the windows, or it may be desirable to hold the tube flat by the use of an internal adhesive or by heat-welding portions of the tube together.

For the solder delivery device of the present invention, as depicted, for example, by each of the embodiments shown, the upper and lower layers of material bordering the solder strip should preferably be made of materials capable of resisting temperatures as high as 400°C for the time needed to melt and flow the solder, which is generally about 15 seconds. Suitable materials include, for example, polyvinylidene fluoride, poly(parabanic acid), and poly(pyromelittimide) or other high-temperature polyamides or -imides. These polymers may be cross-linked by either chemicals or radiation to improve their high-temperature properties.

In embodiments in which the polymeric layers are not of unitary construction, a typical thickness for the upper polymeric layer is about 0.10 mm while a typical thickness for the lower polymeric layer is about 0.18 mm. Of course, when the polymeric layers comprise a single folded sheet or a tube, the thickness of the upper and lower layers is the same, and is typically in the range of from about 0.10 mm to about 0.18 mm. Depending on the application, the solder strip is about 0.15 mm thick.

The width of the polymeric layers will, of course, depend on the application to some extent, but may be, for example, about 5.00 mm with the width of the windows being approximately the length of the connector tab.

## Claims

1. A solder delivery device comprising: two layers of material (30, 36) and a strip of solder (32) disposed therebetween, at least one of the layers (36) having a plurality of windows (38) therein, the windows (38) being arranged to direct the solder from the strip (32) to form a plurality of separate solder connections on heating the delivery device to a temperature sufficiently high to melt the solder, the material of the layers (30, 36) being such as to withstand said temperature.

2. A solder delivery device according to Claim 1, wherein the windows (38) extend through both the layers.

3. A solder delivery device according to Claim 1 or 2, wherein at least one of the layers (30, 36) comprise a polymeric material.

4. A solder delivery device according to any preceding Claim, wherein the windows (38) comprise generally rectangular apertures.

5. A solder delivery device according to any preceding Claim, wherein the windows (60) are louvered.

6. A solder delivery device according to any preceding Claim, wherein at least one of the layers (30, 36) is heat-recoverable.

7. A solder delivery device according to Claim 6, wherein the layer (36) having the windows (38) therein is the heat-recoverable layer.

8. A solder delivery device according to any preceding Claim, wherein the layers (30, 36) comprise separate pieces of material joined along their edges.

9. A solder delivery device according to any preceding Claim, wherein the layers comprise a folded sheet (78).

10. A solder delivery device according to any preceding Claim, wherein the layers comprise a tube (80).

11. A solder delivery device according to any preceding Claim, comprising adhesive or sealant (62) disposed between the layers (30, 36) and on that side of the solder strip (32) which is away from the windows (38).

12. A solder delivery device according to any preceding Claim, comprising a flux disposed between the layers.

13. A solder delivery device according to any preceding Claim, wherein at least one of the layers has a portion (66, 67) extending in a direction away from that of the solder strip.

14. A solder delivery system according to Claim 13, wherein the extended portion (66, 72) comprises a heat-recoverable material.

15. A solder delivery system according to Claim 13 or 14, wherein the extended portion (72) comprises adhesive (58) for bonding the device to a substrate.

16. A solder delivery device according to any one of Claims 13 to 15, wherein the extended portion (72) comprises a plurality of heat-recoverable tubings (74), the tubings (74) being attached to that side of the device which contains the windows (38), being directed away from the solder strip (32), and being aligned with the windows (38), the tubings (24) being arranged to receive subtrates (46) and to dispose parts thereof adjacent the windows (38).

## Revendications

1. Un dispositif distributeur de soudure comprenant: deux couches de matière (30, 36) et une bande de soudure (32) disposée entre elles, l'une au moins des couches (36) comportant une série de fenêtres (38), les fenêtres (38) étant disposées de manière à diriger la soudure provenant de la bande (32) de façon à former une série de connexions soudées séparées à la suite du chauffage du dispositif distributeur à une température suffisamment élevée pour faire fondre la soudure, la matière des couches (30, 36) étant telle qu'elle résiste à ladite température.

2. Un dispositif distributeur de soudure selon la revendication 1, dans lequel les fenêtres (38) traversent les deux couches.

3. Un dispositif distributeur de soudure selon la revendication 1 ou 2, dans lequel l'une au moins des couches (30, 36) est en une matière polymère.

4. Un dispositif distributeur de soudure selon une quelconque revendication précédente, dans lequel les fenêtres (38) sont constituées par des ouvertures approximativement rectangulaires.

5. Un dispositif distributeur de soudure selon une quelconque revendication précédente, dans lequel les fenêtres (60) sont munies d'ouies.

6. Un dispositif distributeur de soudure selon une quelconque revendication précédente, dans lequel l'une au moins des couches (30, 36) précédente, dans lequel l'une au moins des couches (30, 36) présente un caractéristique de reprise thermique.

7. Un dispositif distributeur de soudure selon la revendication 6, dans lequel la couche (36) dans laquelle sont formées les fenêtres (38) est la couche présentant une caractéristique de reprise thermique.

8. Un dispositif distributeur de soudure selon une quelconque revendication précédente, dans lequel les couches (30, 36) sont constituées par des morceaux de matière séparés joints le long de leurs bords.

9. Un dispositif distributeur de soudure selon une quelconque revendication précédente, dans lequel les couches sont constituées par une feuille pliée (78).

10. Un dispositif distributeur de soudure selon une quelconque revendication précédente, dans lequel les couches sont constituées par un tube (80).

11. Un dispositif distributeur de soudure selon une quelconque revendication précédente, comprenant un adhésif ou produit d'étanchéité (62) disposé entre les couches (30, 36) et sur le côté de la bande (32) de soudure qui est situé à l'opposé des fenêtres (38).

12. Un dispositif distributeur de soudure selon une quelconque revendication précédente, comprenant un fondant disposé entre les couches.

13. Un dispositif distributeur de soudure selon une quelconque revendication précédente, dans lequel l'une au moins de couches comporte une partie (66, 67) qui s'étend dans une direction opposée à celle de la bande soudure.

14. Un dispositif distributeur de soudure selon la revendication 13, dans lequel la partie prolongée (66, 72) est et un matière présentant une caractéristique de reprise thermique.

15. Un dispositif distributeur de soudure selon la revendication 13 ou 14, dans lequel la partie prolongée (72) est munie d'un adhésif (58) pour coller le dispositif à un substrat.

16. Un dispositif distributeur de soudure selon l'une quelconque des revendications 13 à 15, dans lequel la partie prolongée (72) comprend une série de tubes (74) à reprise thermique, les tubes (74) étant fixés au côté du dispositif qui comporte les fenêtres, s'étendant dans la direction opposée à celle de la bande (32) de soudure et étant alignés avec les fenêtres (38), les tubes (24) étant disposés de façon à recevoir des substrats (46) et à en disposer des parties adjacentes aux fenêtres (38).

## Patentansprüche

1. Lotzufuhr-Vorrichtung mit: zwei Lagen aus Material (30, 36) und einem zwischen diesen angeordneten Lötmittelband (32), wobei mindestens eine der Lagen (36) eine Anzahl Fenster (38) aufweist, welche so angeordnet sind, daß das Lötmittel aus dem Band (32) so geleitet wird, daß eine Anzahl gesonderter Lötverbindungen beim Beheizen der Zufuhrvorrichtung auf eine Temperatur gebildet wird, die zum Schmelzen des Lötmittels ausreichend hoch ist, wobei das Material der Lagen (30, 36) derart beschaffen ist, daß es dieser Temperatur standhalten kann.

2. Lotzufuhr-Vorrichtung nach Anspruch 1, bei welcher die Fenster (38) sich durch beide Lagen erstrecken.

3. Lotzufuhr-Vorrichtung nach Anspruch 1 oder 2, bei welcher mindestens eine der Lagen (30, 36) durch ein polymeres Material gebildet wird.

4. Lotzufuhr-Vorrichtung nach einem oder mehreren der vorangehendenden Ansprüche, bei welcher die Fenster (38) durch im wesentlichen rechteckige Öffnungen gebildet werden.

5. Lotzufuhr-Vorrichtung nach einem oder mehreren der vorangehenden Ansprüche, bei welcher die Fenster (60) schlitzförmig sind.

6. Lotzufuhr-Vorrichtung nach einem oder mehreren der vorangehenden Ansprüche, bei welcher mindestens eine der Lagen (30, 36) wärmerückstellbar ist.

7. Lotzufuhr-Vorrichtung nach Anspruch 6, bei welcher die Lage (36), in der die Fenster (38) vorgesehen sind, die wärmerückstellbare Lage ist.

8. Lotzufuhr-Vorrichtung nach einem oder mehreren der vorangehenden Ansprüche, bei welcher die Lagen (30, 36) durch gesonderte Materialteile gebildet werden, die längs ihrer Kanten verbunden sind.

9. Lotzufuhr-Vorrichtung nach einem oder mehreren der vorangehenden Ansprüche, bei welcher die Lagen eine gefaltete Folie (78) bilden.

10. Lotzufuhr-Vorrichtung nach einem oder mehreren der vorangehenden Ansprüche, bei welcher die Lagen ein Rohr (80) bilden.

11. Lotzufuhr-Vorrichtung nach einem oder mehreren der vorangehenden Ansprüche mit einem Klebstoff oder Siegelungsmittel (62), welche zwischen den Lagen (30, 36) und auf derjenigen Seite des Lötmittelbandes (32) angeordnet sind, die den Fenstern (38) abgekehrt ist.

12. Lotzufuhr-Vorrichtung nach einem oder mehreren der vorangehenden Ansprüche, mit einem Flußmittel, das zwischen den Lagen vorgesehen ist.

13. Lotzufuhr-Vorrichtung nach einem oder mehreren der vorangehenden Ansprüche, bei welcher mindestens eine der Lagen einen Teil (66, 67) aufweist, der sich in einer Richtung weg von derjenigen des Lötmittelbandes erstreckt.

14. Lotzufuhr-System nach Anspruch 13, bei welchem der erweiterte Teil (66, 72) aus einem wärmerückstellbaren Material besteht.

15. Lotzufuhr-System nach Anspruch 13 oder 14, bei welchem der erweiterte Teil (72) durch einen Klebstoff (58) zur Verbindung der Vorrichtung mit einer Unterschicht gebildet wird.

16. Lotzufuhr-Vorrichtung nach einem oder mehreren der Ansprüche 13 bis 15, bei welcher der erweiterte Teil (72) durch eine Anzahl wärmerückstellbare Rohre (74) gebildet wird, wobei die Rohre (74), die auf derjenigen Seite der Vorrichtung angebracht sind, welche die Fenster (38) enthält, von dem Lötmittelband (32) weg gerichtet und mit den Fenstern (38) ausgefluchtet sind, wobei die Rohre (24) zur Aufnahme von Unterschichten (46) und zur Anordnung von Teilen derselben benachbart den Fenstern (38) eingerichtet sind.

*Fig.1.*

*Fig.2.*

*Fig.3.*

**Fig.4.**

**Fig.5.**

**Fig.6.**

Fig.7.

A   B   C

Fig.8.

Fig.9.

Fig.10.

Fig.11.

32  30

48  60

52  50

Fig.12.

30  56  48

60  52

Fig.13.

30  62

36  32  38

Fig.14.

30  32  40  62  48

52  50

Fig.15.

30  64  40  56  48

52  50

Fig.16.

30

66  17  17  68  36

Fig.17.

68  70  66

Fig.18.

72  36  32  30

58  38

Fig.19.

Fig.20.

Fig.21.

Fig.22.

Fig. 23.